# EUROPEAN PATENT APPLICATION

(11) **EP 2 860 871 A1**
(43) Date of publication of application: **15.04.2015**
(21) Application number: 14157752.8
(22) Date of filing: 05.03.2014
(51) Int. Cl.: H02P 27/08, H02P 29/00, H02H 7/085

(54) **Motor protection device, motor protection method, and motor control system using the same**

(30) Priority: 10.10.2013 KR 20130120763
(71) Applicant: Samsung Electro-Mechanics Co., Ltd., Suwon-si, Gyeonggi-do 443-743 (KR)
(72) Inventor: Joung, Ho Son, 443-734 Youngtong-Gu, Suwon-Si Gyeonggi-Do (KR); Jang, Nam Hong, 443-743 Youngtong-Gu, Suwon-Si Gyeonggi-Do (KR); Ha, Keun Soo, 443-743 Youngtong-Gu, Suwon-Si Gyeonggi-Do (KR)
(74) Representative: Heine, Christian Klaus

(57) **Abstract**

Disclosed herein are a motor protection device, a motor protection method, and a motor control system using the same. According to the present invention, the motor protection device including: a rotation speed change sensing unit that senses and outputs pulse widths of a pulse signal outputted from a rotation sensor installed in a motor; an abnormality determining unit that outputs abnormality-occurrence signal if the pulse widths of the pulse signal outputted from the rotation speed change sensing unit increase beyond a predetermined value; and a stopping unit that stops operation of a motor control system if the abnormality-occurrence signal is outputted from the abnormality determining unit, the motor protection method, and the motor control system using the same are provided.

## Description

### CROSS REFERENCE TO RELATED APPLICATION

This application claims the benefit of Korean Patent Application No. 10-2013-0120763, filed on October 10, 2013, entitled "Motor Protection Device, Motor Protection Method, and Motor Control System using the Same," which is hereby incorporated by reference in its entirety into this application.

### BACKGROUND OF THE INVENTION

### 1. Technical Field

The present invention relates to a motor protection device, a motor protection method, and a motor control system using the same.

### 2. Description of the Related Art

In general, a motor control system controls a motor such that it receives household alternating current power, converts it into direct current power, and converts it into alternating current power at a predetermined voltage to drive the motor.

Such a motor control systems includes a converter that converts an AC voltage into a DC voltage, an inverter that switches a DC voltage in an alternating current manner, and a motor.

In the motor control system, overcurrent at the DC input terminal is detected by a detection circuit through a detection resistance and transmitted to a control unit. The overcurrent of the AC power applied to the motor is detected as an analog signal by a current sensor, and is converted into a digital signal by an analog-digital converter and then reads by the control unit as a data value and processed in a software manner.

The inverter includes a plurality of power semiconductor devices and gate driving signals from a gate driving/interrupting circuit controlled by the control unit are applied to the gates of the power semiconductor devices.

Overcurrent introduced into the motor is one of the reasons which damages the motor control systems.

As described above, existing motor protection devices use a current sensor to sense a current introducing into a motor and stop the motor or interrupting power when the value of the sensed overcurrent exceeds a given overcurrent value.

Using a current sensor to stop outputting when an abnormal current peak occurs is the most effective way to prevent damage to the motor control systems.

However, since current sensors are expensive, causing the prices of motor control systems to be increased, they are not frequently employed in practice.

For this reason, instead of using a current sensor, a fuse is used in order to interrupt current. However, the behavior of a fuse is slow, so that a motor control system may be damaged by overcurrent before a fuse is out.

### [Prior Art Document]

### [Patent Document]

(Patent Document 1) Korean Patent Laid-Open Publication No. 2008-0104869

### SUMMARY OF THE INVENTION

The present invention has been made in an effort to provide motor protection device and method that sense a change in rotation speed of a motor, and determine that there is abnormality so as to stop the motor, when the rotation speed rapidly changes.

Further, the present invention has been made in an effort to provide a motor control system using the motor protection device.

According to a first preferred embodiment of the present invention, there is provided a motor protection device including: a rotation speed change sensing unit that senses and outputs pulse widths of a pulse signal outputted from a rotation sensor installed in a motor; an abnormality determining unit that outputs abnormality-occurrence signal if the pulse widths of the pulse signal outputted from the rotation speed change sensing unit increase beyond a predetermined value; and a stopping unit that stops operation of a motor control system if the abnormality-occurrence signal is outputted from the abnormality determining unit.

The rotation speed change sensing unit may include: an edge detector that outputs a generation signal whenever a rising edge and a falling edge of a pulse signal outputted from the rotation sensor are generated; a timer that outputs clock signals with a predetermined pulse width; and a pulse width sensor that calculates and outputs a pulse width by measuring a difference in time between the rising edge and the falling edge outputted from the edge detector based on the clock signals outputted from the timer.

The edge detector may include: a rising edge detector that outputs a generation signal whenever a rising edge is generated, by detecting the rising edge of pulse signals inputted from the rotation sensor; and a falling edge detector that outputs a generation signal whenever a falling edge is generated, by detecting the falling edge of pulse signals inputted from the rotation sensor.

The abnormality determining unit may output the abnormality-occurrence signal if the pulse width of a current pulse signal outputted from the rotation speed change sensing unit increases beyond the pulse width of the immediate preceding pulse signal by a predetermined value or more.

The abnormality determining unit may output the abnormality-occurrence signal if the pulse width of a pulse signal outputted from the rotation speed change sensing unit increases beyond the pulse width of the immediate preceding pulse signal by a predetermined value or more and the number of the pulse signals with pulse widths increasing beyond the average pulse width of the immediate preceding pulse signal by the predetermined value or more is equal to or more than a predetermined number.

The abnormality determining unit may output the abnormality-occurrence signal if the pulse width of a current pulse signal outputted from the rotation speed change sensing unit increases beyond the pulse width of the immediate preceding pulse signal by a predetermined value or more.

The abnormality determining unit may output the abnormality-occurrence signal if the pulse width of a current pulse signal outputted from the rotation speed change sensing unit increases beyond the pulse width of the immediate preceding pulse signal by a predetermined value or more and the number of the pulse signals with pulse widths increasing beyond the pulse width of the immediate preceding pulse signal by the predetermined value or more is equal to or more than a predetermined number.

The stopping unit may stop the operation of an inverter of a motor control system if the abnormality determining unit outputs the abnormality-occurrence signal.

The stopping unit may stop operation of an inverter of a motor control system by supplying an off-signal to power semiconductor devices of the inverter when the abnormality determining unit outputs the abnormality-occurrence signal.

According to a second preferred embodiment of the present invention, there is provided a motor control system including: a converter that converts AC power into DC power and outputs the DC power; an inverter that drives a motor by switching the DC power outputted from the converter in an alternating current manner; a rotation sensor that is installed in the motor to generate and output a pulse signal corresponding to rotation of a rotator of the motor; and a motor protection device that senses the pulse width of a pulse signal outputted from the rotation sensor and stops the operation of the inverter when the pulse width increases beyond a predetermined value.

The motor protection device may include a rotation speed change sensing unit that senses and outputs pulse widths of a pulse signal outputted from a rotation sensor installed in a motor; an abnormality determining unit that outputs abnormality-occurrence signal if the pulse widths of the pulse signal outputted from the rotation speed change sensing unit increase beyond a predetermined value; and a stopping unit that stops operation of a motor control system if the abnormality-occurrence signal is outputted from the abnormality determining unit.

The rotation speed change sensing unit may include: an edge detector that outputs a generation signal whenever a rising edge and a falling edge of a pulse signal outputted from the rotation sensor are generated; a timer that outputs clock signals with a predetermined pulse width; and a pulse width sensor that calculates and outputs a pulse width by measuring a difference in time between the rising edge and the falling edge outputted from the edge detector based on the clock signals outputted from the timer.

The abnormality determining unit may output the abnormality-occurrence signal if the pulse width of a current pulse signal outputted from the rotation speed change sensing unit increases beyond the pulse width of the immediate preceding pulse signal by a predetermined value or more.

The abnormality determining unit may output the abnormality-occurrence signal if the pulse width of a current pulse signal outputted from the rotation speed change sensing unit increases beyond the pulse width of the immediate preceding pulse signal by a predetermined value or more and the number of the pulse signals with pulse widths increasing beyond the pulse width of the immediate preceding pulse signal by the predetermined value or more is equal to or more than a predetermined number.

According to a third preferred embodiment of the present invention, there is provided a motor protection method including: (a) sensing and outputting, by a rotation speed change sensing unit, a pulse width of a pulse signal outputted from a rotation sensor installed in a motor;(b) outputting, by an abnormality determining unit, an abnormality-occurrence signal if the pulse width of the pulse signal outputted from the rotation speed change sensing unit increases beyond a predetermined value; and (c) stopping, by a stopping unit, operation of a motor control system if the abnormality-occurrence signal is outputted from the abnormality determining unit.

The (a) sensing and outputting may include: (a-1) outputting, by an edge detector of the rotation speed change sensing unit, a generation signal whenever a rising edge and a falling edge of a pulse signal outputted from the rotation sensor are generated; and (a-2) calculating and outputting, by a pulse width sensor of the rotation speed change sensing unit, a pulse width by measuring a difference in time between a rising edge and a falling edge outputted from the edge detector based on a clock signal outputted from a timer.

The (b) outputting may include outputting the abnormality-occurrence signal if the pulse width of a current pulse signal outputted from the rotation speed change sensing unit increases beyond the pulse width of the immediate preceding pulse signal by a predetermined value or more.

The (b) outputting may include outputting the abnormality-occurrence signal if the pulse width of the current pulse signal outputted from the rotation speed change sensing unit is 1.3 times or more and 3 times or less the pulse width of the immediate preceding pulse signal.

The (b) outputting may include outputting the abnormality-occurrence signal if the pulse width of a pulse signal outputted from the rotation speed change sensing unit increases beyond the pulse width of the immediate preceding pulse signal by a predetermined value or more and the number of pulse signals with pulse widths increasing beyond the pulse width of the immediate preceding pulse signal by a predetermined value or more is equal to or more than a predetermined number.

The (b) outputting may include outputting the abnormality-occurrence signal if the pulse width of the current pulse signal outputted from the rotation speed change sensing unit increases beyond the average pulse width of the immediate preceding pulse signals by a predetermined value or more.

The (b) outputting may include outputting the abnormality-occurrence signal if the pulse width of a current pulse signal outputted from the rotation speed change sensing unit increases beyond the average pulse width of the immediate preceding pulse signals by a predetermined value or more and the number of pulse signals with pulse widths increasing beyond the pulse width of the immediate preceding pulse signal by a predetermined value or more is equal to or more than a predetermined number.

### BRIEF DESCRIPTION OF THE DRAWINGS

The above and other objects, features and advantages of the present invention will be more clearly understood from the following detailed description taken in conjunction with the accompanying drawings, in which:
FIG. 1 is a block diagram of a motor protection device according to a first preferred embodiment of the present invention;
FIG. 2 is a diagram illustrating an example of a pulse signal outputted from the rotation speed change sensing unit of FIG. 1;
FIG. 3 is a block diagram of the rotation speed change sensing unit of FIG. 1;
FIG. 4 is a diagram illustrating the process of detecting edges in an edge detector;
FIG. 5 is a block diagram of a motor control system using the motor protection device of FIG. 1;
FIG. 6 is a diagram illustrating an example of the BLDC motor of FIG. 5;

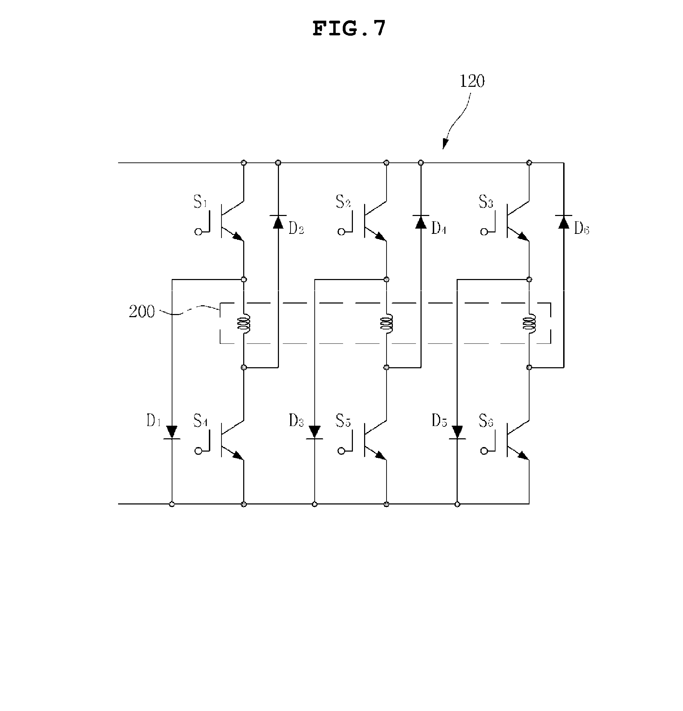

FIG. 7 is a diagram illustrating the SRM motor of FIG. 5; and
FIG. 8 is a flowchart illustrating a motor protection method according to a first preferred embodiment of the present invention.

### DESCRIPTION OF THE PREFERRED EMBODIMENTS

The objects, features and advantages of the present invention will be more clearly understood from the following detailed description of the preferred embodiments taken in conjunction with the accompanying drawings. Throughout the accompanying drawings, the same reference numerals are used to designate the same or similar components, and redundant descriptions thereof are omitted. Further, in the following description, the terms "first," "second," "one side," "the other side" and the like are used to differentiate a certain component from other components, but the configuration of such components should not be construed to be limited by the terms. Further, in the description of the present invention, when it is determined that the detailed description of the related art would obscure the gist of the present invention, the description thereof will be omitted.

Hereinafter, preferred embodiments of the present invention will be described in detail with reference to the attached drawings.

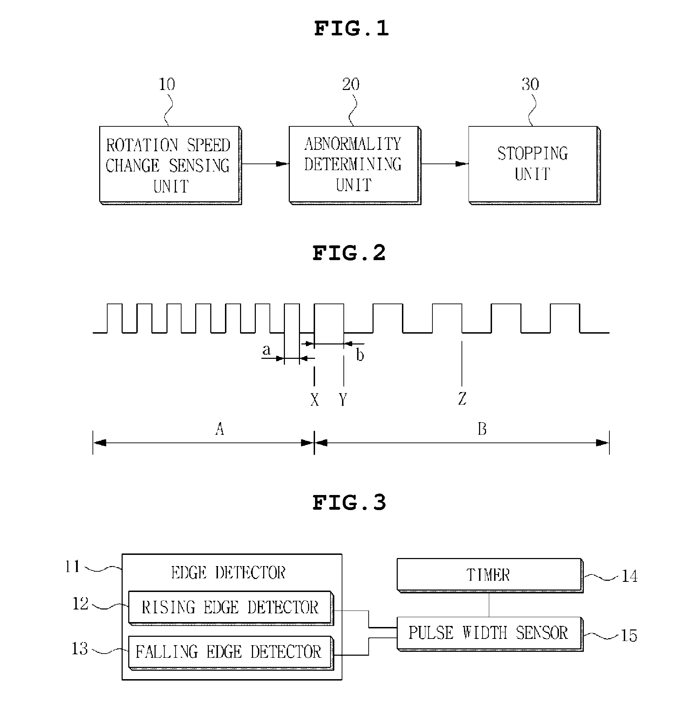

FIG. 1 is a block diagram of a motor protection device according to a first preferred embodiment of the present invention.

Referring to FIG. 1, the motor protection device according to the first preferred embodiment of the present invention may include a rotation speed change sensing unit 10, an abnormality determining unit 20, and a stopping unit 30.

The rotation speed change sensing unit 10 senses the pulse width of a pulse signal outputted from a rotation sensor and outputs it to the abnormality determining unit 20.

The abnormality determining unit 20 determines that there is abnormality in the motor control system and outputs an abnormality-occurrence signal if the pulse width of the pulse signal outputted from the rotation speed change sensing unit 10 increases beyond a predetermined value.

The stopping unit 30 stops the operation of the motor control system if the abnormality determining unit 20 determines that there is abnormality in the motor control system.

The operation of the motor protection device according to the first preferred embodiment of the present invention will be described below.

First, the rotation speed change sensing unit 10 monitors pulse signals outputted from the rotation sensor.

An example of a pulse signal monitored by the rotation speed change sensing unit 10 is shown in FIG. 2, in which when the pulse signal is in the normal period A, the pulse signal propagates with slightly increased or decreased pulse width compared to previous pulse widths.

This means that the rotation of the rotator of the motor gently increases or decrease, showing normal operation when there is no abnormality in the motor control system.

However, when a pulse signal is generated in the abnormal period B, it can be seen that the pulse width more rapidly increases than in the normal period A.

This means that the operation of the motor rapidly decreases due to malfunction of the motor control system.

In this regard, the increase in pulse width means a decrease in rotation speed.

An example of such a case may be found in a cleaner motor. That is, when the fan for sucking air into the cleaner motor is broken, the motor rapidly slows down and the pulse signal such as in the abnormal period B shown in FIG. 2 is generated.

If this situation lasts for a while, the power semiconductor devices in the motor control system are broken due to the increase in current.

When the rotation speed change sensing unit 10 senses and outputs pulse widths, the abnormality determining unit 20 compares the pulse width of the pulse signal currently outputted with the pulse width of the immediately preceding pulse signal, and determines that there is abnormality in the motor control system and outputs a abnormality-occurrence signal if there is a rapid change in pulse width.

The abnormality determining unit 20 may determine that there is abnormality in the motor control system if the pulse width (b) outputted from the rotation speed change sensing unit 10 is, for instance, 1.3 times or more the pulse width (a) inputted immediately before.

If the rotation sensor has abnormality so that it outputs a pulse signal that does reflecting the rotation of the motor, the abnormality determining unit 20 may ignore a very large increase in the pulse width (b) outputted from the rotation speed change sensing unit 10 compared to the pulse width (a) inputted immediately before so as to prevent malfunction.

For example, the abnormality determining unit 20 may determine that there is abnormality in the motor control system if the pulse width (b) outputted from the rotation speed change sensing unit 10 is 1.3 times or more the pulse width (a) inputted immediately before.

Further, when a predetermined number or more of sequential pulse widths outputted from the rotation speed change sensing unit 10 have a certain magnitude larger than that of the immediate preceding pulse width with respect to the start point of time, the abnormality determining unit 20 may determine that there is abnormality in the motor control system to thereby output an abnormality-occurrence signal.

Referring to FIG. 2, when pulse widths outputted from the rotation speed change sensing unit 10 have a certain magnitude larger than the immediate preceding pulse width by a predetermined value or more with respect to the start point X and they appear sequentially over a predetermined number, for example, three, the abnormality determining unit 20 outputs an abnormality-occurrence signal at that point of time, i.e., Z.

When the abnormality determining unit 20 outputs an abnormality-occurrence system on not the point of time Y but on the point of time Z where a predetermined number of pulse widths are generated, in FIG. 2, reliability of the abnormality-occurrence signal may be improved.

Although the abnormality determining unit 20 has the pulse width immediate before the abnormal period B as the reference, it is not limited thereto and may sense a change in pulse width in the abnormal period B using the average after summing up the pulse widths of several pulse signals in the normal period A.

That is, the abnormality determining unit 20 may calculate the average after summing up a predetermined number or more of pulse width and determine changes in the subsequent pulse width on the basis of the average.

When the abnormality determining unit 20 determines a change in pulse widths in the abnormal period B in this manner, it is possible to increase reliability by using the average of the pulse widths of previous several pulse signals.

When the abnormality determining unit 20 determines abnormal operation of the motor control system using the pulse widths outputted from the rotation speed change sensing unit 10 as described above, the stopping portion 30 stops the operation of the motor control system.

In particular, the stopping unit 30 may stop the operation of the motor control system by stopping the operation of the inverter of the motor control system, and stops the operation of the motor control system by issuing off-signals to the power semiconductor devices of the inverter.

According to the present invention described above, overcurrent may be prevented without using an expensive current sensor, so that the manufacturing cost of a motor control system may be saved.

Further, according to the present invention, damage to a motor control system due to an overcurrent may be prevented.

FIG. 3 is a block diagram of the rotation speed change sensing unit of FIG. 1.

Referring to FIG. 3, the rotation speed change sensing unit of FIG. 1 includes an edge detector 11, a timer 14, and a pulse width sensor 15.

The edge detector 11 serves to detect rising edges and falling edges of pulse signals outputted from the rotation sensor and outputs a generation signal to the pulse width sensor 15 whenever a rising edge and a falling edge are generated.

To this end, the edge detector 11 may include a rising edge detector 12 and a falling edge detector 13.

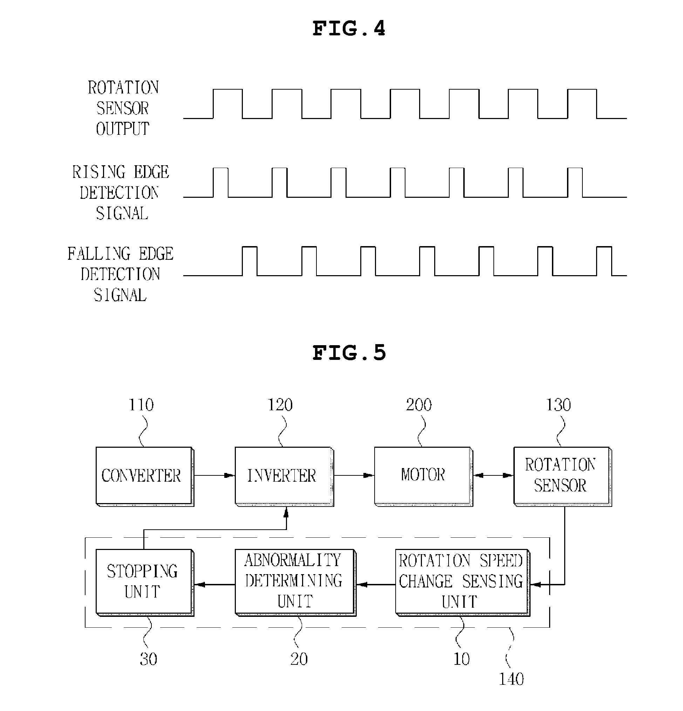

The rising edge detector 12, as shown in FIG. 4, detects the rising edge of a pulse signal inputted from the rotation sensor and outputs a generation signal to the pulse width sensor 15 whenever a rising edge is generated.

The falling edge detector 13, as shown in FIG. 4, detects the falling edge of a pulse signal inputted from the rotation sensor and outputs a generation signal to the pulse width sensor 15 whenever a falling edge is generated.

Then, the timer 14 outputs clock signals with a predetermined pulse width which is relatively much small compared to the pulse width outputted from the rotation sensor.

The pulse width sensor 15 calculates and outputs a pulse width by measuring the difference of time between a rising edge and a falling edge outputted from the edge detector 11 using a clock signal outputted from the timer 14.

It is to be noted that the edge detector 11 includes the rising edge detector 12 and the falling edge detector 13 separately because it is advantageous in increasing the accuracy in edge detection.

FIG. 5 is a block diagram of a motor control system using the motor protection device of FIG. 1.

Referring to FIG. 5, the motor control system using the motor protection device of FIG. 1 includes a converter 110, an inverter 120, a rotation sensor 130, and a motor protection device 140.

The converter 110 converts AC power into DC power and then outputs it.

The inverter 120 drives a motor 200 by switching a DC voltage outputted from the converter 110 in an alternating current manner.

The rotation sensor 130 is mounted on the motor 200, generates and outputs pulse signals corresponding to rotation of the rotation of a rotor of the motor 200, and is implemented by a hall device or the like.

The motor protection device 140, as shown in FIG. 1, includes the rotation speed change sensing unit 10, the abnormality determining unit 20, and the stopping unit 30, senses the pulse width and determining whether there is abnormality, when the rotation sensor 130 of the motor 200 outputs a pulse signal, and then stops the inverter 120 when there is abnormality.

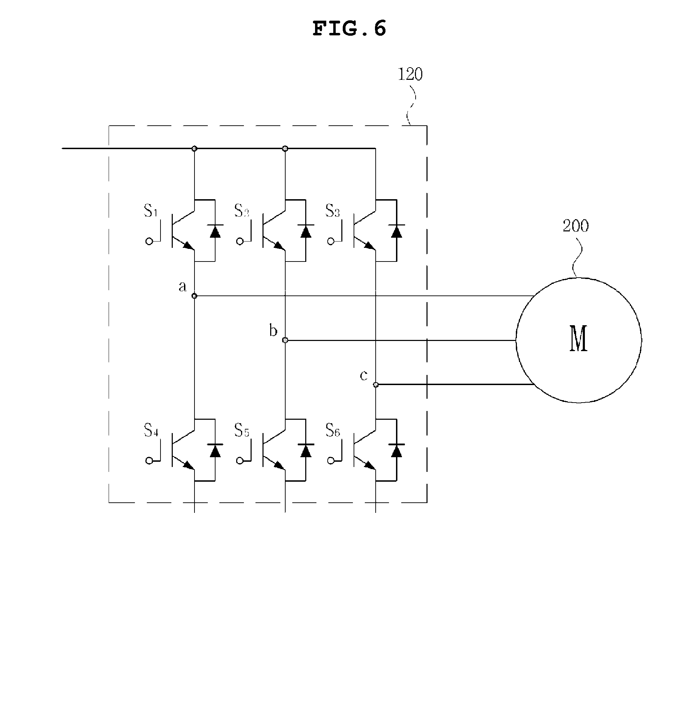

In this configuration, the motor 200 may be a BLDC motor, and an example of the inverter 120 in the case of the BLDC motor is shown in FIG. 6 which is composed of six power semiconductor devices S1 to S6.

Alternatively, the motor 200 may be an SRM motor, and an example of the inverter 120 in the case of the SRM motor is shown in FIG. 6 which is of six power semiconductor devices S1 to S6 and six diodes D1 to D6.

The stopping unit 30 stops the power semiconductor devices S 1 to S6 of the inverter 120 by turning them off.

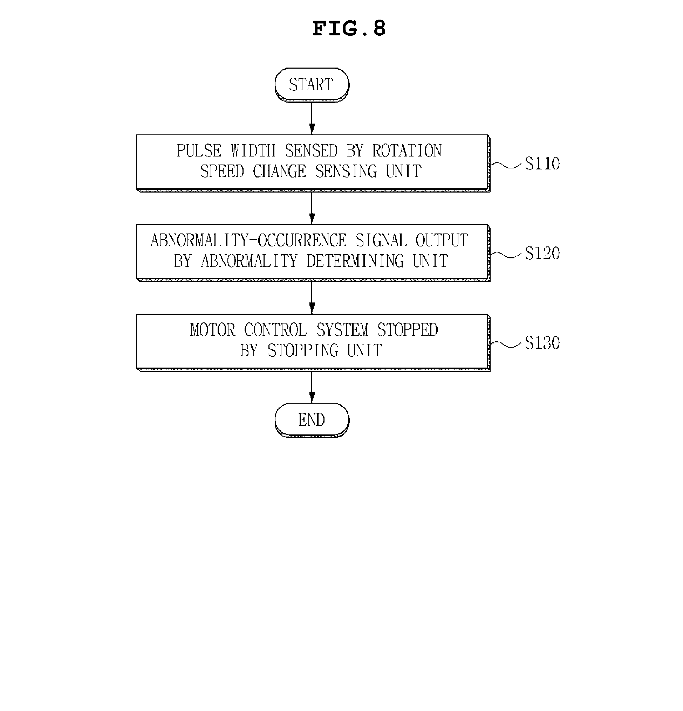

FIG. 8 is a flowchart illustrating a motor protection method according to a first embodiment of the present invention.

Referring to FIG. 8, first, the rotation speed change sensing unit 10 monitors a pulse signal outputted from the rotation sensor to detect pulse widths (S 110). When the pulse signal monitored by the rotation speed change sensing unit is in the normal period A, it means that with the pulse width progresses, slight increasing or decreasing more than the previous pulse width and the rotation of a rotor of the motor smoothly increases or decreases, but it shows normal operation when there is no abnormality in the motor control device.

However, when a pulse signal is generated in the abnormal period, it can be seen that the pulse width rapidly increases more than when the pulse width in the normal period, and it means that the operation of the motor rapidly decreases due to an abnormality in the motor control system.

In this regard, the increase in pulse width means a decrease in rotation speed.

An example of such a case may be found in a cleaner motor. That is, when the fan for sucking air into the cleaner motor is broken, the motor rapidly slows down and the pulse signal such as in the abnormal period B shown in FIG. 2 is generated.

The operation of the rotation speed change sensing unit 10 includes the processes in which the edge detector 11 outputs a generation signal to the pulse width sensor 15 whenever a rising edge and a falling edge are generated, and the pulse width sensor 15 calculates and outputs a pulse width by measuring the a difference in time between a rising edge and a falling edge outputted from the edge detector 11 using a clock signal outputted from the timer 14.

When the rotation speed change sensing unit 10 senses and outputs a pulse width, the abnormality determining unit 20 compares the pulse width of the pulse signal outputted now with the right previous pulse width, and determines that there is abnormality with the motor control system and outputs a abnormality-occurrence signal, when there is a rapid change in the pulse widths (S 120).

The abnormality determining unit 20 may determine that there is abnormality in the motor control system if the pulse width (b) outputted from the rotation speed change sensing unit 10 is, for instance, 1.3 times or more the pulse width (a) inputted immediately before.

If the rotation sensor has abnormality so that it outputs a pulse signal that does not reflect the rotation of the motor, the abnormality determining unit 20 may ignore a very large increase in the pulse width (b) outputted from the rotation speed change sensing unit 10 compared to the pulse width (a) inputted immediately before so as to prevent a malfunction.

For example, the abnormality determining unit 20 may determine that there is abnormality in the motor control system if the pulse width (b) outputted from the rotation speed change sensing unit 10 is 1.3 times or more the pulse width (a) inputted immediately before.

Further, when a predetermined number or more of sequential pulse widths outputted from the rotation speed change sensing unit 10 have a certain magnitude larger than that of the immediate preceding pulse width with respect to the start point of time, the abnormality determining unit 20 may determine that there is abnormality in the motor control system to output an abnormality-occurrence signal.

Although the abnormality determining unit 20 has the pulse width immediate before the abnormal period B as the reference, it is not limited thereto and may sense a change in pulse width in the abnormal period B using the average after summing up the pulse widths of several pulse signals in the normal period A.

When the abnormality determining unit 20 determines an abnormal operation of the motor control system using the pulse widths outputted from the rotation speed change sensing unit 10 as described above, the stopping portion 30 stops the operation of the motor control system (S 130).

In particular, the stopping unit 30 may stop the operation of the motor control system by stopping the operation of the inverter of the motor control system, and stops the operation of the motor control system by issuing off-signals to the power semiconductor devices of the inverter.

According to the present invention described above, overcurrent may be prevented without using an expensive current sensor, so that the manufacturing cost of a motor control system may be saved.

Further, according to the present invention, damage to a motor control system due to an overcurrent may be prevented.

As set forth above, according to preferred embodiments of the present invention, overcurrent may be prevented without employing a costly current sensor, so that the manufacturing cost of a motor control system may be saved.

Further, according to preferred embodiments of the present invention, damage to a motor control system due to overcurrent may be prevented.

Although the embodiments of the present invention have been disclosed for illustrative purposes, it will be appreciated that the present invention is not limited thereto, and those skilled in the art will appreciate that various modifications, additions and substitutions are possible, without departing from the scope and spirit of the invention.

Accordingly, any and all modifications, variations or equivalent arrangements should be considered to be within the scope of the invention, and the detailed scope of the invention will be disclosed by the accompanying claims.

## Claims

1. A motor protection device comprising:
a rotation speed change sensing unit that senses and outputs pulse widths of a pulse signal outputted from a rotation sensor installed in a motor;
an abnormality determining unit that outputs abnormality-occurrence signal if the pulse widths of the pulse signal outputted from the rotation speed change sensing unit increase beyond a predetermined value; and
a stopping unit that stops operation of a motor control system if the abnormality-occurrence signal is outputted from the abnormality determining unit.

2. The motor protection device as set forth in claim 1, wherein the rotation speed change sensing unit includes:
an edge detector that outputs a generation signal whenever a rising edge and a falling edge of a pulse signal outputted from the rotation sensor are generated;
a timer that outputs clock signals with a predetermined pulse width; and
a pulse width sensor that calculates and outputs a pulse width by measuring a difference in time between the rising edge and the falling edge outputted from the edge detector based on the clock signals outputted from the timer.

3. The motor protection device as set forth in claim 2, wherein the edge detector includes:
a rising edge detector that outputs a generation signal whenever a rising edge is generated by detecting the rising edge of a pulse signal inputted from the rotation sensor; and
a falling edge detector that outputs a generation signal whenever a falling edge is generated by detecting the falling edge of the pulse signal inputted from the rotation sensor.

4. The motor protection device as set forth in claim 1, wherein the abnormality determining unit outputs the abnormality-occurrence signal if the pulse width of a current pulse signal outputted from the rotation speed change sensing unit increases beyond the pulse width of the immediate preceding pulse signal by a predetermined value or more.

5. The motor protection device as set forth in claim 4, wherein the abnormality determining unit outputs the abnormality-occurrence signal if the pulse width of the current pulse signal outputted from the rotation speed change sensing unit is 1.3 times or more and 3 times or less the pulse width of the immediate preceding pulse signal.

6. The motor protection device as set forth in claim 1, wherein the abnormality determining unit outputs the abnormality-occurrence signal if the pulse width of a current pulse signal outputted from the rotation speed change sensing unit increases beyond the pulse width of the immediate preceding pulse signal by a predetermined value or more and the number of the pulse signals with pulse widths increasing beyond the pulse width of the immediate preceding pulse signal by the predetermined value or more is equal to or more than a predetermined number.

7. The motor protection device as set forth in claim 1, wherein the abnormality determining unit outputs the abnormality-occurrence signal if the pulse width of the current pulse signal outputted from the rotation speed change sensing unit increases beyond the average pulse width of immediate preceding pulse signals by a predetermined value or more.

8. The motor protection device as set forth in claim 1, wherein the abnormality determining unit outputs the abnormality-occurrence signal if the pulse width of a current pulse signal outputted from the rotation speed change sensing unit increases beyond the average pulse width of immediate preceding pulse signals by a predetermined value or more and the number of pulse signals with pulse widths increasing beyond the pulse width of the right previous pulse signal by the predetermined value or more is equal to or more than a predetermined number.

9. The motor protection device as set forth in claim 1, wherein the stopping unit stops operation of an inverter of a motor control system when the abnormality determining unit outputs the abnormality-occurrence signal.

10. The motor protection device as set forth in claim 1, wherein the stopping unit stops operation of an inverter of a motor control system by supplying an off-signal to power semiconductor devices of the inverter when the abnormality determining unit outputs the abnormality-occurrence signal.

11. A motor control system comprising:
a converter that converts AC power into DC power and outputs the DC power;
an inverter that drives a motor by switching the DC power outputted from the converter in an alternating current manner;
a rotation sensor that is installed in the motor to generate and output a pulse signal corresponding to rotation of a rotator of the motor; and
a motor protection device that senses the pulse width of a pulse signal outputted from the rotation sensor and stops the operation of the inverter when the pulse width increases beyond a predetermined value.

12. The motor control system as set forth in claim 11, wherein the motor protection device includes:
a rotation speed change sensing unit that senses and outputs pulse widths of a pulse signal outputted from a rotation sensor installed in a motor;
an abnormality determining unit that outputs abnormality-occurrence signal if the pulse widths of the pulse signal outputted from the rotation speed change sensing unit increase beyond a predetermined value; and
a stopping unit that stops operation of a motor control system if the abnormality-occurrence signal is outputted from the abnormality determining unit.

13. The motor control system as set forth in claim 12, wherein the rotation speed change sensing unit includes:
an edge detector that outputs a generation signal whenever a rising edge and a falling edge of a pulse signal outputted from the rotation sensor are generated;
a timer that outputs clock signals with a predetermined pulse width; and
a pulse width sensor that calculates and outputs a pulse width by measuring a difference in time between the rising edge and the falling edge outputted from the edge detector based on the clock signals outputted from the timer.

14. The motor control system as set forth in claim 11, wherein the abnormality determining unit outputs the abnormality-occurrence signal if the pulse width of a current pulse signal outputted from the rotation speed change sensing unit increases beyond the pulse width of the immediate preceding pulse signal by a predetermined value or more.

15. The motor control system as set forth in claim 11, wherein the abnormality determining unit outputs the abnormality-occurrence signal if the pulse width of a current pulse signal outputted from the rotation speed change sensing unit increases beyond the pulse width of the immediate preceding pulse signal by a predetermined value or more and the number of the pulse signals with pulse widths increasing beyond the pulse width of the immediate preceding pulse signal by the predetermined value or more is equal to or more than a predetermined number.

16. A motor protection method, comprising:
(a) sensing and outputting, by a rotation speed change sensing unit, a pulse width of a pulse signal outputted from a rotation sensor installed in a motor;
(b) outputting, by an abnormality determining unit, an abnormality-occurrence signal if the pulse width of the pulse signal outputted from the rotation speed change sensing unit increases beyond a predetermined value; and
(c) stopping, by a stopping unit, operation of a motor control system if the abnormality-occurrence signal is outputted from the abnormality determining unit.

17. The motor protection method as set forth in claim 16, wherein the (a) sensing and outputting includes:
(a-1) outputting, by an edge detector of the rotation speed change sensing unit, a generation signal whenever a rising edge and a falling edge of a pulse signal outputted from the rotation sensor are generated; and
(a-2) calculating and outputting, by a pulse width sensor of the rotation speed change sensing unit, a pulse width by measuring a difference in time between a rising edge and a falling edge outputted from the edge detector based on a clock signal.

18. The motor protection method as set forth in claim 16, wherein the (b) outputting includes outputting, by the abnormality determining unit, the abnormality-occurrence signal if the pulse width of a current pulse signal outputted from the rotation speed change sensing unit increases beyond the pulse width of the immediate preceding pulse signal by a predetermined value or more.

19. The motor protection method as set forth in claim 16, wherein the (b) outputting includes outputting, by the abnormality determining unit, the abnormality-occurrence signal if the pulse width of the current pulse signal outputted from the rotation speed change sensing unit is 1.3 times or more and 3 times or less the pulse width of the immediate preceding pulse signal.

20. The motor protection method as set forth in claim 16, wherein the (b) outputting includes outputting, by the abnormality determining unit, the abnormality-occurrence signal if the pulse width of a pulse signal outputted from the rotation speed change sensing unit increases beyond the pulse width of the immediate preceding pulse signal by a predetermined value or more and the number of pulse signals with pulse widths increasing beyond the pulse width of the immediate preceding pulse signal by a predetermined value or more is equal to or more than a predetermined number.

21. The motor protection method as set forth in claim 16, wherein the (b) outputting includes outputting, by the abnormality determining unit, the abnormality-occurrence signal if the pulse width of the current pulse signal outputted from the rotation speed change sensing unit increases beyond the average pulse width of the immediate preceding pulse signals by a predetermined value or more.

22. The motor protection method as set forth in claim 16, wherein the (b) outputting includes outputting, by the abnormality determining unit, the abnormality-occurrence signal if the pulse width of a pulse signal outputted from the rotation speed change sensing unit increases beyond the average pulse width of the immediate preceding pulse signals by a predetermined value or more and the number of pulse signals with pulse widths increasing beyond the pulse width of the immediate preceding pulse signal by a predetermined value or more is equal to or more than a predetermined number.
